# EUROPEAN PATENT APPLICATION

(11) **EP 4 621 855 A1**
(43) Date of publication of application: **24.09.2025**
(21) Application number: 23891926.0
(22) Date of filing: 10.11.2023
(51) Int. Cl.: H01L 31/18, H01L 23/00

(54) **SOLDERING DEVICE AND TABBING DEVICE COMPRISING SAME**

(30) Priority: 14.11.2022 KR 20220151519
(71) Applicant: Hanwha Solutions Corporation, Seoul 04541 (KR)
(72) Inventor: JUNG, Min Kyo, Seoul 04541 (KR); CHUNG, Dong Jin, Seoul 04541 (KR); JEON, Sung Gyu, Seoul 04541 (KR)
(74) Representative: Mooser, Sebastian Thomas
(86) International application number: PCT/KR2023/018053
(87) International publication number: WO 2024/106859

(57) **Abstract**

This soldering device may comprise a stage on which a solar cell and a wire are seated, a body facing the stage, and multiple heaters provided on the bottom surface of the body so as to face the solar cell and the wire. The stage may comprise a support portion having multiple guide pins configured to ascend from below so as to support the wire toward the solar cell.

## Description

### [Technical Field]

The present invention relates to a soldering device and a tabbing device including the same.

### [Background Art]

A solar cell, i.e., a solar battery, is formed by positioning diodes having p-n junctions on a substrate. When sunlight is radiated onto the solar cell, exitons in electron-hole pairs are generated, and as the exitons are separated, electrons are moved to an n layer, and holes are moved to a p layer. Accordingly, a photoelectro-motive force is generated in p-n junction portions. Tabbing is a process of forming one solar cell module by positioning wires on a plurality of solar cells and electrically connecting the plurality of solar cells.

A tabbing device includes a soldering device as a bonding device for connecting the plurality of solar cells. The soldering device electrically connects the solar cells and the wires by melting solder on the wires in a state in which the wires are positioned on the solar cells. This soldering process needs to firmly support the solar cells and the wires in order to connect the solar cells and the wires at designated positions. However, the conventional tabbing device does not have a component that supports the solar cells and the wires during the soldering process, or does not have a component that merely presses the solar cells and the wires only from the top but may not strongly push the solar cells and the wires upward from the bottom or not prevent misalignment of the wire.

In particular, a large-area solar cell may be locally sagged or bent by a weight thereof while a solar cell is seated on the soldering device and moves. When soldering is performed without correcting this misaligned position, the solar cell and the wire cannot be connected properly.

### [Detailed Description of Invention]

### [Technical Problem]

The present invention is directed to providing a soldering device capable of supporting a solar cell and a wire during a soldering process and a tapping device including the same.

### [Technical Solution]

A soldering device includes a stage on which a solar cell and a wire are seated, a body facing the stage, and a plurality of heaters on a bottom surface of the body so as to face the solar cell and the wire, wherein the stage includes a support having a plurality of guide pins raised from below to support the wire toward the solar cell.

The support may include a pin adjustment block including a controller and air passages, each of which communicates with one of the plurality of guide pins, and the controller may open or close the air passage and vertically move the plurality of guide pins.

When the air passages are open, supplied air may raise the plurality of guide pins to support the wire, and when the air passages are closed, the plurality of guide pins may be lowered and may not be in contact with the wire.

The support may include a first housing positioned on the pin adjustment block and including a plurality of first lifting holes into which a plurality of lifting pins are inserted, and when the air passage is open, the plurality of lifting pins may be raised to raise the plurality of guide pins corresponding thereto.

The support may include a second housing having a plurality of second lifting holes into which the plurality of guide pins are inserted and having an uneven part including a plurality of concave portions and protrusions and formed on an upper surface thereof, and the plurality of guide pins may overlap the uneven part.

The support may selectively support the wire by raising at least some of the plurality of guide pins using air.

The support may include a plurality of support parts spaced apart from each other in one direction and having upper surfaces on which a plurality of wires are positioned to be spaced apart from each other in the one direction.

A tabbing device for seating a solar cell and a wire jig on a wire on a wire transfer device and soldering the solar cell and the wire to form a solar cell module includes a soldering device including a stage on which a solar cell and a wire are seated, a body facing the stage, and a plurality of heaters on a bottom surface of the body so as to face the solar cell and the wire, wherein the stage includes a support having a plurality of guide pins raised from below to support the wire toward the solar cell.

### [Advantageous Effects]

A soldering device and a tabbing device including the same can support a wire during a soldering process so that the wire and a solar cell can be connected to each other properly.

Since a soldering device and a tabbing device including the same can support a wire toward a solar cell using a plurality of guide pins positioned to correspond to a connection point between the wire and the solar cell, the wire and the solar cell can be connected to each other more properly.

A soldering device and a tabbing device including the same can prevent a wire from escaping from a designated position or sagging downward during a soldering process by pressing the wire toward a solar cell.

### [Description of Drawings]

FIG. 1 is schematic view illustrating a tabbing device.
FIG. 2 illustrates a state in which a solar cell and a wire are connected.
FIG. 3 illustrates a soldering process of a soldering device.
FIG. 4 illustrates a stage of the soldering device.
FIG. 5 illustrates a cross section of a support.
FIG. 6 illustrates a second housing.
FIG. 7 illustrates a state in which the wire is seated on the support.
FIG. 8 is an enlarged view of an upper surface of the second housing.
FIG. 9 shows a state in which the support supports the wire.

### [Best Mode]

A soldering device includes a stage on which a solar cell and a wire are seated, a body facing the stage, and a plurality of heaters on a bottom surface of the body so as to face the solar cell and the wire, wherein the stage includes a support having a plurality of guide pins raised from below to support the wire toward the solar cell.

### [Modes of the Invention]

Hereinafter, the present disclosure will be described with reference to embodiments exemplified in the accompanying drawings. The described embodiments are not limited to content described in the specification and may have different forms. Thus, the embodiments are merely described below with reference to the accompanying drawings to describe aspects and features of the present invention.

The present disclosure includes various embodiments and modifications, and specific embodiments will be exemplified in the accompanying drawings and described in the following description. However, the present disclosure is not limited to the above-described embodiments and includes all modifications, equivalents, or substitutes included in the spirit and scope of the present invention.

When it is mentioned that an element or layer is located "on" another element or layer or "connected" or "coupled" to another element or layer, the element or layer may be directly connected or coupled to another element or layer. Alternatively, one or more elements or layers may be additionally present. When it is mentioned that the element or layer is located "directly on" another element or layer or "directly connected" or "directly coupled" to another element or layer, no other intermediate element or layer may be present therebetween. For example, when it is mentioned that a first element and a second element are "coupled" or "connected," the first element may be directly coupled or connected to the second element, or the first element may be indirectly coupled or connected to the second element through one or more intermediate elements.

Dimensions of various elements, layers, etc., in the drawings may be exaggerated for clarity of illustration. The same reference numerals may refer to the same elements. As used herein, the term "and/or" includes any and all combinations of one or more of associated listed items. Further, when embodiments of the present disclosure are described, the use of "can" is related to "one or more embodiments of the present disclosure." When expressions such as "at least one" and "anyone" are described before a list of elements, the expressions may change the total list of the elements but not change individual elements of the list. For example, an expression such as "at least one of a, b, or c" may refer to only a, only b, only c, both a and b, both a and c, both b and c, all of a, b, and c, or a variation thereof. As used herein, the terms "use," "using," and "used" may be considered synonymous with the terms "utilize," "utilizing" and "utilized," respectively. The terms "substantially," "about," and similar terms used herein are used as terms of approximation rather than terms of degree and are intended to describe intrinsic variations in measured or calculated values recognizable to those skilled in the art.

Terms such as first, second, and third may be used to describe various elements, components, regions, layers, and/or sections, but these elements, components, regions, layers, and/or the sections are not limited to these terms. These terms are used to distinguish one element, component, region, layer, or section from another element, component, region, layer, or section. Thus, a first element, a first component, a first region, a first layer, or a first section discussed below may be named a second element, a second component, a second region, a second layer, or a second section without departing from the disclosure of the exemplary embodiments.

Spatially relative terms such as "below," "under," "on," and "above" may be used herein for convenience of description to describe a relationship between features of one element or (an)other element(s) or function(s) described in the drawings. The spatially relative terms may include other directions of a device in use or operation in addition to directions depicted in the drawings. For example, when the device in the drawing is turned over, an element described to be "under" or "below" another element or feature may be oriented "on" or "above" another element or feature. Thus, the term "under" may include both upward and downward directions. The device may be directed in a different direction (90° rotation or in a different direction) and spatially relative descriptors used herein should be interpreted accordingly.

Terms used herein are used to describe the embodiments of the present invention and are not intended to limit the present invention. A singular form used herein may also include a plural form unless the context clearly indicates otherwise. The terms "include," "have," and "constitute" specify features, integers, steps, operations, elements, and/or components when used herein but do not exclude the presence or addition of one or more other functions, integers, steps, operations, elements, components, and/or groups thereof.

When embodiments may be implemented as a process, a specific process order may be performed differently from a described order. For example, two processes described in succession may be performed simultaneously or substantially in a simultaneous manner or may be performed in a reverse order with respect to the described order.

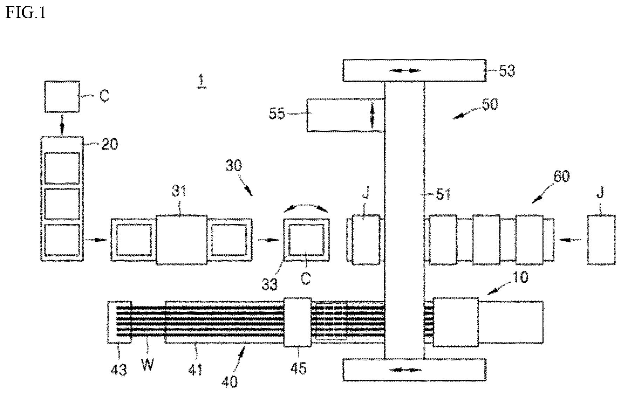

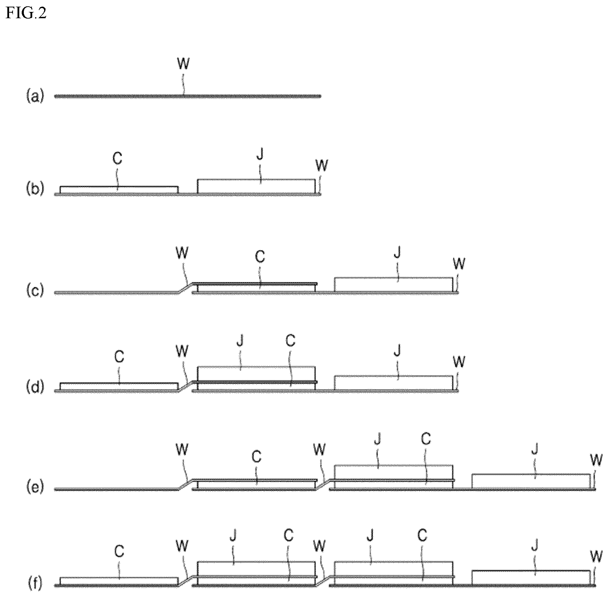

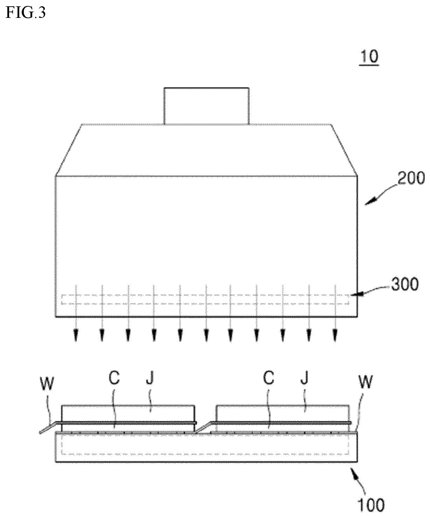

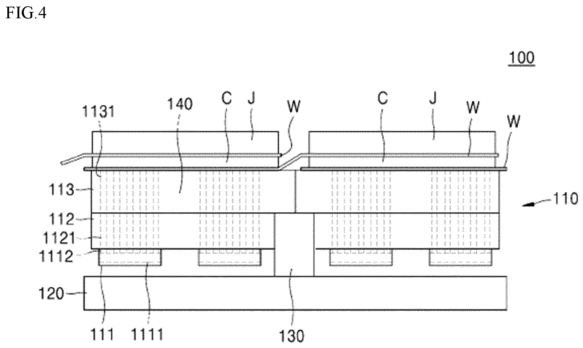

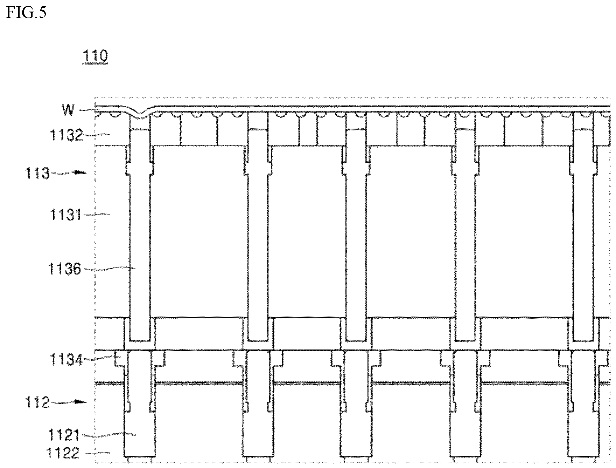

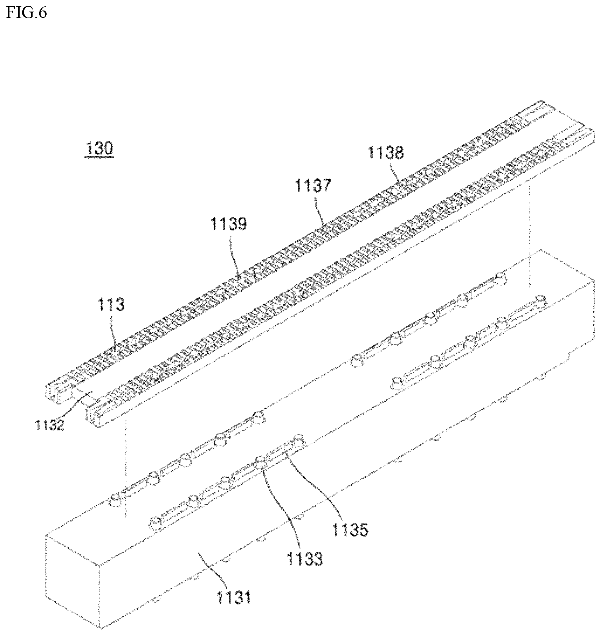

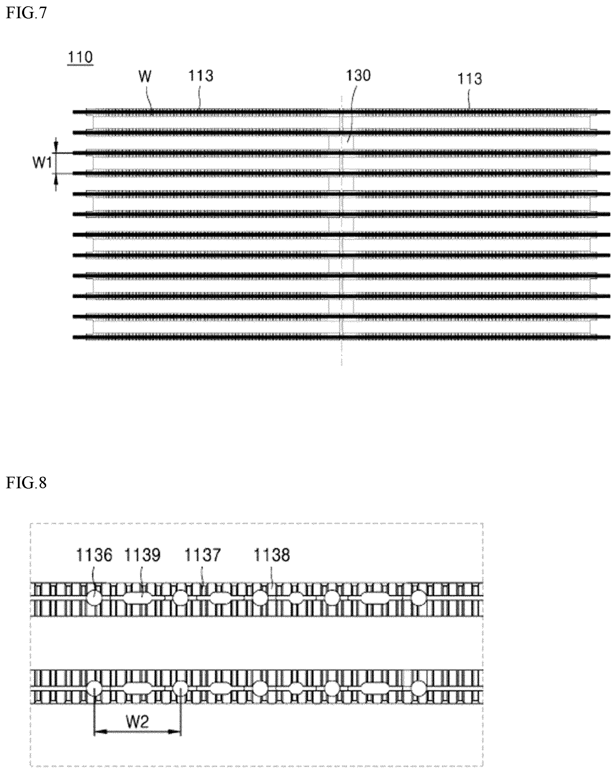

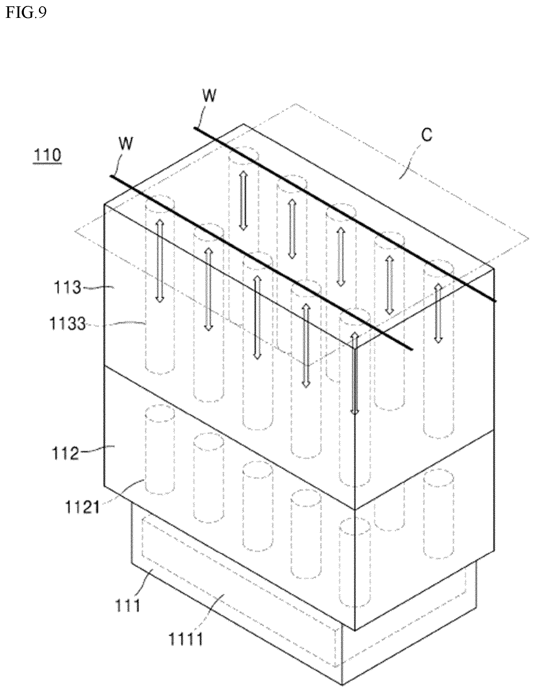

FIG. 1 is schematic view illustrating a tabbing device 1, FIG. 2 illustrates a state in which a solar cell C and a wire W are connected, FIG. 3 illustrates a soldering process of a soldering device 10, FIG. 4 illustrates a stage 100 of the soldering device 10, FIG. 5 illustrates a cross section of a support 110, FIG. 6 illustrates a second housing 113, FIG. 7 illustrates a state in which the wire W is seated on the support 110, FIG. 8 is an enlarged view of an upper surface of the second housing 113, and FIG. 9 shows a state in which the support 119 supports the wire W.

The tabbing device 1 is a device for forming a solar cell module by connecting the solar cell C and the wire W. The solar cell C may have a semiconductor junction area having a p-n junction surface and generate an electromotive force to convert optical energy into electrical energy when a certain amount or more of energy is radiated. Materials of semiconductors included in the solar cell C are not particularly limited, and (single crystal, polycrystalline, and amorphous) silicon, gallium arsenide, cadmium tellur, cadmium sulfide, indium phosphorus, copper indium gallium selenide (CIGS), organic dyes, or mixtures thereof may be used as the materials.

The wire W is a conductor for electrically connecting a plurality of solar cells C to each other and connects a front surface and a rear surface of the neighboring solar cells C to each other. For example, the wire W may be electrically connected to the solar cell C through the soldering process. Alternatively, the wire W may be electrically connected to the solar cell C through an electrically conductive adhesive ECA.

The wire jig J fixes the wire W to prevent the wire W from being lifted or escaping from a designated position when the solar cell C and the wire W are connected. For example, as illustrated in FIG. 1, in a state in which the wire W is positioned on a wire transfer device 40, the wire jig J may be seated on the wire transfer device 40 to press the wire W. Further, the wire jig J may be supported and transferred by a moving device 50, which will be described below.

For example, as illustrated in FIG. 1, the tabbing device 1 may include the soldering device 10, a solar cell transfer device 20, a solar cell supply device 30, the wire transfer device 40, the moving device 50, and a wire jig transfer device 60.

The soldering device 10 is positioned to perform an end process of the tabbing device 1 and forms the solar cell module by bonding the wire W and the solar cell C. For example, the soldering device 10 may electrically connect the solar cell C and the wire W by melting solder in a state in which the solar cell C is seated on the wire W. The soldering device 10 will be described below.

The solar cell transfer device 20 is positioned on one side of the tabbing device 1 and transmits the solar cell C to the solar cell supply device 30. For example, as illustrated in FIG. 1, the solar cell transfer device 20 may receive the solar cell C from an external device or pick up the solar cell C loaded in a magazine or the like and transfer the solar cell C to the solar cell supply device 30. For example, the solar cell transfer device 20 may be a conveyor for transferring the solar cell C in one direction (e.g., an up-to-down direction in FIG. 1). Further, FIG. 1 illustrates one solar cell transfer device 20, but the present invention is not limited thereto. There may be two or more solar cell transfer devices 20.

The solar cell supply device 30 divides the solar cell C received from the solar cell transfer device 20 according to size and transmits the divided solar cell C to the moving device 50. For example, the solar cell supply device 30 may include a scriber 31 and a stage 33.

The scriber 31 divides the solar cell C received from the solar cell transfer device 20 into a size suitable for the solar cell module. For example, the scriber 31 may divide the solar cell C into a plurality of parts using a breaking device after a laser is radiated onto an upper surface of the solar cell C.

The stage 33 may move to a predetermined position in a state in which the divided solar cells C are supported so that the moving device 50 may support the solar cell C. The stage 33 may move in three-axis directions such as X-axis, Y-axis, and Z-axis directions and may rotate about the Z-axis to correct a position of the solar cell C. Further, the stage 33 may support the wire jig J in addition to the solar cell C. That is, the wire jig J transferred by the wire jig transfer device 60, which will be described below, may be seated on the stage 33, and the moving device 50 may support the solar cell C and the wire jig J to seat the solar cell C and the wire jig J on the wire W.

The wire transfer device 40 may be spaced apart from the solar cell supply device 30. The wire transfer device 40 may transfer a plurality of wires W. For example, the wire transfer device 40 is a conveyor belt that extends to be elongated in a direction (e.g., a left-right direction of FIG. 1 or a transfer direction of the wire W) perpendicular to a movement direction (e.g., an up-down direction of FIG. 1) of a cell-jig transfer part 55 and may transfer a plurality of (e.g., six or more) wires W. For example, as illustrated in FIG. 7, 12 wires W may be spaced a distance D1 from each other. In this case, a soldering material, e.g., solder, may be applied or plated onto the wire W supplied to the wire transfer device 40. For example, in an embodiment, a dipping unit (not illustrated) for applying or plating the soldering material onto the wire W may be further included, and the wire W passing through the dipping unit may be provided to the wire transfer device 40.

For example, when the solar cell C and the wire jig J approach the wire W via the cell-jig transfer part 55, the wire transfer device 40 is temporarily stopped so that the solar cell C and the wire jig J are seated on the wire W. Thereafter, the wire transfer device 40 may be operated again to transfer the wire W.

The moving device 50 moves the solar cell C and the wire jig J to the wire W. For example, as illustrated in FIG. 1, the moving device 50 may be positioned across the wire transfer device 40 and the wire jig transfer device 60. That is, the moving device 50 may overlap the wire transfer device 40 and the wire jig transfer device 60 in a plan view. Further, the moving device 50 may include a first support 51 and a second support 53 and may include the cell-jig transfer part 55 moving along the first support 51.

The first support 51 is a frame extending to be elongated across the wire jig transfer device 60 and the wire transfer device 40 and both ends thereof may be connected to the second support 53. The second support 53 may extend in a direction intersecting the first support 51, and the first support 51 may adjust a position of the cell-jig transfer part 55 while moving in a longitudinal direction of the second support 53.

The cell-jig transfer part 55 may move in the longitudinal direction of the first support 51, support the solar cell C and the wire jig J, and seat the solar cell C and the wire jig J on the wire W. For example, the cell-jig transfer part 55 may simultaneously or separately support the solar cell C and the wire jig J seated on the stage 33. Further, the cell-jig transfer part 55 may seat the supported solar cell C and the supported wire jig J on the wire W seated on the wire transfer device 40.

The wire jig transfer device 60 may be spaced apart from the solar cell supply device 30 and the wire transfer device 40. The wire jig transfer device 60 receives the wire jig J and transmits the wire jig J to the moving device 50. The wire jig transfer device 60 moves the plurality of wire jigs J toward the stage 33 and stops the wire jig J at an end portion adjacent to the stage 33. In this state, a transport device that is not illustrated may transport the wire jig J onto the stage 33.

Referring to FIGS. 1 and 2, a process of tabbing, by the tabbing device 1, the wire W and the solar cell C using the wire jig J will be described.

First, when the wire W is supplied by the wire transfer device 40 (see FIG. 2A), the moving device 50 seats a pair of the solar cell C and the wire jig J on the wire W (see FIG. 2B). Further, the wire transfer device 40 seats another wire W on the solar cell C (see FIG. 2C), and the moving device 50 seats the pair of the solar cell C and the wire jig J on this wire W (see FIG. 2D). The wire transfer device 40 seats the wire W on the solar cell C again (see FIG. 2E), and the moving device 50 seats the pair of the solar cell C and the wire jig J on the wire (see FIG. 2F). Therefore, the solar cell C and the wire W may be electrically connected, and the wire jig J may support the wire W until the soldering process so that the wire W does not escape from a designated position.

The soldering device 10 may heat the solar cell C and the wire W. For example, the soldering device 10 may heat the solder positioned on a surface of the wire W to a temperature at which the solder is melted. Accordingly, the wire W and the solar cell C may be thermally bonded by molten solder and may be physically and electrically connected.

Referring to FIGS. 3 to 9, the soldering device 10 may include a stage 100, a body 200, and a heater 300.

The stage 100 may support the solar cell C and the wire W and include a heater (not illustrated) for heating the solar cell C and the wire W. For example, the stage 100 receives the solar cell C, the wire W, and the wire jig J for supporting the solar cell C and the wire W from the wire transfer device 40 and supports the solar cell C, the wire W, and the wire jig J. Here, the solar cell C, the wire W, and the wire jig J seated on the stage 100 may have a shape illustrated in FIG. 2. Further, the stage 100 may support the solar cell C and the wire W and move the solar cell C and the wire W to a designated position.

For example, the stage 100 may be provided in the form of a conveyor. For example, the stage 100 may be a portion of the conveyor of the wire transfer device 40 or a separate conveyor connected to the conveyor of the wire transfer device 40.

In another embodiment, the stage 100 may be independently moved. For example, the stage 100 is a shuttle-type transport device and may transport the solar cell C and the wire W while reciprocating between an end portion of the wire transfer device 40 and a discharged position. For example, the stage 100 may move to the wire transfer device 40 to receive the solar cell C and the wire W and may move to a position corresponding to the body 200 for the soldering process. Thereafter, when the soldering process is completed, the stage 100 may move to the discharged position.

For example, the stage 100 may support the wire W during the soldering process and maintain a position thereof. In a process of moving the stage 100 during the soldering process, when the solar cell C, the wire W, and the wire jig J supporting the solar cell C and the wire W move minutely or escape from a designated position, bonding quality between the solar cell C and the wire W may be degraded. To prevent this, the stage 100 may support the wires W to arrange positions thereof.

For example, the stage 100 may support the wire W by lifting a pin provided therein using air. The lifted pin may lift the wire W from below to prevent sagging of the wire W. Alternatively, the stage 100 may lift the wire W using an air injection method such as an air knife.

For example, the stage 100 may include a support 110. As illustrated in FIG. 4, the solar cell C, the wire W, and the wire jig J may be seated on an upper surface of the support 110, and the support 110 may support the wire W to prevent positional misalignment of the wire W.

For example, the support 110 may include a pin adjustment block 111, a first housing 112, and a second housing 113.

The pin adjustment block 111 is positioned on one side of the support 110 and is connected to an air supply source that is not illustrated. For example, as illustrated in FIG. 4, the pin adjustment block 111 is positioned under the support 110, e.g., under the first housing 112. Further, the pin adjustment block 111 may be connected to the air supply source and distribute air to lift a guide pin 1133, which will be described below.

The pin adjustment block 111 may include a controller 1111 and an air passage 1112.

As illustrated in FIG. 4, the controller 1111 may be positioned under the pin adjustment block 111 and connected to the air supply source. When the controller 1111 operates the air supply source, the pin adjustment block 111 may support the wire W by lifting all of a plurality of guide pins 1133 or individually lifting some of the plurality of guide pins 1133. For example, the controller 1111 may include a plurality of electronic valves provided to correspond to the plurality of guide pins 1133, a processor, a communication module, and a memory. The controller 1111 may receive a preset program or an instruction of a user to open only a passage to be lifted or close the other passages to individually or integrally lift the plurality of guide pins 1133.

The air passage 1112 is positioned inside the pin adjustment block 111 and serves as a passage through which air introduced from the air supply source moves to the first housing 112 and the second housing 113. For example, the number of the air passages 1112 may be the same as the number of lifting pins 1121, which will be described below, and guide pins 1133. For example, the number of the air passages 1112 included in the one pin adjustment block 111 is 12, and six air passages 1112 may be positioned in two columns. Further, each of the air passages 1112 may overlap the lifting pin 1121 and the guide pin 1133.

For example, the plurality of air passages 1112 may be connected to the controller 1111 and may be individually opened or closed by the controller 1111. Accordingly, air introduced from the air supply source may be introduced into the air passage 1112 opened by the controller 1111 to lift the lifting pin 1121 and the guide pin 1133.

The first housing 112 may be positioned on the pin adjustment block 111, and the lifting pin 1121 may be provided therein. For example, as illustrated in FIG. 4, the first housing 112 may be positioned between the pin adjustment block 111 and the second housing 113. Further, the first housing 112 may have a plurality of first lifting holes 1122 communicating with the air passages 1112, and the lifting pins 1121 may be inserted into first lifting holes 1122.

For example, the first housing 112 may have a block shape extending to be elongated in one direction. For example, as illustrated in FIGS. 4 and 6, the first housing 112 may have a rectangular parallelepiped shape extending in a moving direction of the solar cell C.

The plurality of first lifting holes 1122 may be positioned inside the first housing 112, and the lifting pins 1121 may be positioned inside the first lifting holes 1122. Each of the plurality of first lifting holes 1122 may have one end communicating with the air passage 1112 of the pin adjustment block 111 and the other end communicating with a second lifting hole 1134 of the second housing 113. Accordingly, air introduced from the air passage 1112 pushes the lifting pin 1121 positioned inside the first lifting hole 1122 upward. Further, one end of the lifting pin 1121 may be in contact with the guide pin 1133, the guide pin 1133 may be in contact with the wire W, and thus the wire W may be supported.

As illustrated in FIG. 5, in a state in which air is not supplied from the air supply source, an upper end of the lifting pin 1121 may remain to be spaced apart from a lower end of the guide pin 1133. Thereafter, when air is supplied, the lifting pin 1121 may be raised to push the guide pin 1133 upward.

For example, one first housing 112 may correspond to the plurality of pin adjustment blocks 111. For example, as illustrated in FIG. 4, two pin adjustment blocks 111 may be positioned under the one first housing 112. Here, a length of each pin adjustment block 111 may correspond to a length of one solar cell C.

The second housing 113 may support the solar cell C, the wire W, and the wire jig J and may be positioned above the first housing 112. For example, as illustrated in FIG. 4, an upper surface of the second housing 113 may be in direct contact with the wire W.

For example, the second housing 113 may include a lower block 1131 and an upper plate 1132.

The lower block 1131 may be positioned under the second housing 113, and the guide pin 1133 and the second lifting hole 1134 may be positioned inside the lower block 1131. The same number of the second lifting holes 1134 may be provided at positions corresponding to the first lifting holes 1122 of the first housing 112, and the guide pin 1133 may be positioned inside the second lifting hole 1134.

The upper plate 1132 may be positioned on the lower block 1131 and have an upper surface on which the wire W may be seated. For example, as illustrated in FIGS. 5 and 6, the lower block 1131 may include a plurality of insertion protrusions 1135 on an upper surface thereof, and the upper plate 1132 may include insertion grooves 1139 corresponding thereto. The insertion protrusion 1135 may be positioned between the neighboring guide pins 1133 and protrude from the upper surface of the lower block 1131 to a predetermined height. The upper plate 1132 may be stably fixed to the lower block 1131 by inserting the insertion protrusions 1135 into the insertion grooves 1139.

The guide pin 1133 is positioned between the lower block 1131 and the upper plate 1132, is lifted while inserted into the second lifting hole 1134 and a third lifting hole 1136, and lifts the wire W. For example, as illustrated in FIG. 5, the guide pin 1133 may have a rod shape extending to be elongated in a longitudinal direction. In a state in which air is not supplied, i.e., in a state in which the lifting pin 1121 is not raised, an upper end of the guide pin 1133 may be positioned below the upper surface of the second housing 113. In more detail, as illustrated in FIG. 5, an edge portion of the guide pin 1133 may be seated in a step formed inside the second lifting hole 1134, and thus the guide pin 1133 may stay at a designated position. Thereafter, the air supplied from the air supply source pushes the lifting pin 1121 upward, the lifting pin 1121 comes into contact with the lower end of the guide pin 1133, and thus the guide pin 1133 is raised. Further, an upper end of the guide pin 1133 comes into contact with the wire W, the solar cell C and the wire W comes into close contact with each other well, and thus a connection point between the solar cell C and the wire W may be firmly supported during the soldering process. Further, the guide pin 1133 may push and support the downwardly sagging wire W upward.

For example, the plurality of guide pins 1133 may be positioned in a plurality of columns in the one support 110. For example, as illustrated in FIGS. 6 and 8, a plurality of third lifting holes 1136 are positioned in two columns to be spaced apart from each other on an upper surface of the upper plate 1132, and the guide pins 1133 may be inserted into the third lifting holes 1136. Here, the wire W may overlap a virtual line connecting the neighboring guide pins 1133.

For example, the neighboring guide pins 1133 may be spaced a distance D2 from each other. The distance D2 may be in a range of 5% to 25% of the entire length of the wire W supported on the one support 110 and may preferably be in a range of 10% to 20% thereof. When the distance D2 is smaller than 10% of the entire length of the wire W, the number of the guide pins 1133 in comparison to the wire W may excessively increase, and thus the entire configuration of the device may become complicated. Further, when the heater provided in the stage 100 heats the wire W, an area in which the guide pin 1133 covers the wire W increases, and thus heating efficiency may be degraded. When the distance D2 is greater than 20% of the entire length of the wire W, a gap between the guide pins 1133 is excessively increased, and thus the wire W cannot be sufficiently supported with respect to the solar cell C, and sagging of the wire W cannot be prevented properly.

For example, a diameter of the guide pin 1133 and the third lifting hole 1136 may be smaller than a width of the wire W. Accordingly, the wire W seated on the upper plate 1132 can be prevented from excessively sagging toward a lower side of the third lifting hole 1136.

For example, the upper plate 1132 may be provided with the third lifting hole 1136. As illustrated in FIGS. 5 and 6, the third lifting hole 1136 may be positioned to correspond to the second lifting hole 1134, and the number of the third lifting holes 1136 may be the same as the number of the second lifting holes 1134.

For example, the upper plate 1132 may further include an uneven part. As shown in FIGS. 5 and 6, the uneven part faces the wire W on the upper surface of the upper plate 1132. A plurality of concave portions 1137 and a plurality of convex portions 1138 may be alternately positioned on the uneven part. Accordingly, in a state in which the wire W is seated on the support 110, the wire W may be in contact with an upper surface of the convex portion 1138 and may not be in contact with the concave portion 1137. That is, a gap may be formed between the wire W and the concave portion 1137, and thus the wire W may more smoothly move on the stage 100. Further, the heat generated by the heater provided in the stage 100 circulates inside the gap to efficiently heat the solar cell C and the wire W.

For example, the uneven part may have a width greater than that of the wire W. As illustrated in FIGS. 7 and 8, the concave portion 1137 and the convex portion 1138 included in the uneven part may be positioned at both ends of the upper plate 1132 in a width direction and may be positioned to correspond to the wire W. Here, a width of each of the concave portion 1137 and the convex portion 1138 may be greater than that of the wire W, and thus the wire W may be stably supported.

For example, the plurality of guide pins 1133 may overlap the uneven part. For example, as illustrated in FIGS. 6 and 8, the plurality of third lifting holes 1136 may be positioned on the concave portion 1137 and the convex portion 1138, and the plurality of guide pins 1133 may be inserted into the third lifting holes 1136. Here, the third lifting hole 1136 may be positioned on a central line of the concave portion 1137 and the convex portion 1138 in the width direction.

For example, the upper plate 1132 may further include an insertion groove 1139. As illustrated in FIGS. 6 and 8, the insertion groove 1139 may be positioned between the neighboring third lifting holes 1136 and may be positioned to correspond to the insertion protrusion 1135 of the lower block 1131. Accordingly, the insertion protrusion 1135 is inserted into the insertion groove 1139, and thus the lower block 1131 and the upper plate 1132 may be stably fixed. A shape of the insertion groove 1139 is not particularly limited and may be a shape corresponding to the insertion protrusion 1135. For excellent fastening between the lower block 1131 and the upper plate 1132, the insertion groove 1139 may have a long slot shape in a longitudinal direction, i.e., in the moving direction of the solar cell C.

For example, the stage 100 may include a main frame 120 and a support frame 130.

As illustrated in FIG. 4, the main frame 120 is positioned below the support 110 and supports other components of the stage 100. The support frame 130 is positioned on the main frame 120 and connects the support 110 to the main frame 120. For example, the support frame 130 may be positioned on a central portion of the stage 100 and extend in the width direction, a lower surface thereof may be positioned on the main frame 120, and an upper surface thereof may support the second housing 113.

For example, the support 110 may be provided as a plurality of supports 110. For example, as illustrated in FIG. 4, each support 110 may be positioned on one of one side and the other side with respect to the support frame 130 such that the supports 110 are symmetrical to each other. Each of the supports 110 may support and cool one or more solar cells C. FIG. 7 illustrates that the six supports 110 are positioned on each of one side and the other side of the support frame 130, but the number of the supports 110 is not particularly limited. The number of the supports 110 may be appropriately selected according to specifications of the solar cell C and the wire W.

For example, the one support 110 may support the plurality of wires W. For example, as illustrated in FIG. 7, the two wires W may be spaced a distance W1 from both ends of the one support 110 in the width direction. Further, the neighboring supports 110 may be spaced the distance W1 from each other. Accordingly, all the plurality of wires W seated on the stage 100 may be spaced the same distance W1 from each other. However, the number of the wires W supported on the one support 110 is not limited to two. For example, when the guide pins 1133 included in the one support 110 are arranged to form three or more columns, the same number of the wires W may also be arranged.

The body 200 may face the stage 100 and may melt solder by radiating light or applying heat to the solar cell C and the wire W seated on the stage 100. For example, as illustrated in FIG. 3, the body 200 may be spaced upward from an upper surface of the stage 100, and when the solar cell C and the wire W are seated on the stage 100, solder applied to a connection portion between the solar cell C and the wire W may be melted. For example, the heater 300 facing the solar cell C and the wire W may melt solder applied to the wire W by radiating light having a specific wavelength or applying heat to the bottom of the body 200. For example, the heater 300 may serve as an ultraviolet lamp and may melt solder by radiating ultraviolet rays onto the solder applied to the wire W. Alternatively, the heater 300 may melt solder by heating the solder at a predetermined temperature. The plurality of heaters 300 may be spaced apart from each other in a longitudinal direction of the solar cell C.

Next, an operation of the soldering device 10 will be described with reference to FIGS. 1 to 9.

The solar cell C and the wire jig J are seated on the wire W transferred by the wire transfer device 40 and then are transferred to the stage 100 of the soldering device 10. When the wire W is positioned on the stage 100 at a designated position, air supplied from the air supply source moves to the controller 1111. The controller 1111 may open the air passage 1112 corresponding to the guide pin 1133 to be raised in consideration of the positions and moving speeds of the solar cell C and the wire W. For example, the controller 1111 may supply air to the air passage 1112 corresponding to the 12 guide pins 1133 to simultaneously raise the 12 guide pins 1133 provided in one support 110. Alternatively, the controller 1111 may supply air to the corresponding air passage 1112 to raise only the guide pin 1133 at a specific position.

The supplied air may push the lifting pin 1121 inserted into the first lifting hole 1122 upward, and as an upper end of the lifting pin 1121 and a lower end of the guide pin 1133 come into contact with each other, the guide pin 1133 may be raised to come into contact with the wire W. In this way, as the guide pin 1133 comes into contact with the wire W, the wire W and the solar cell C may firmly come into contact with each other during the soldering process. Further, sagging and positional escape of the wire W can be prevented.

Thereafter, when the guide pin 1133 is to be lowered, the controller 1111 closes the air passage 1112. Accordingly, air supplied from the air supply source is not transferred to the air passage 1112, and as the lifting pin 1121 is lowered, the guide pin 1133 is also lowered.

For example, an operation of raising the guide pin 1133 may be performed throughout the soldering process. For example, the operation may be performed at any timing before or after the soldering device 10 radiates light and emits heat to melt the solder or before or after the soldering device 10 cools the melted solder.

In this way, the present invention has been described with reference to the embodiments illustrated in the accompanying drawings, but this is merely an example. Those skilled in the art may fully understand that various modifications and other equivalent embodiments may be derived from the embodiments. Thus, the true technical protection scope of the present invention should be determined based on the appended claims.

### [Industrial Applicability]

The present invention can be used in industries related to a soldering device and a tabbing device including the same.

## Claims

1. A soldering device comprising:
a stage on which a solar cell and a wire are seated;
a body facing the stage; and
a plurality of heaters on a bottom surface of the body so as to face the solar cell and the wire,
wherein the stage includes a support having a plurality of guide pins raised from below to support the wire toward the solar cell.

2. The soldering device of claim 1, wherein the support includes a pin adjustment block including a controller and air passages, each of which communicates with one of the plurality of guide pins, and
the controller opens or closes the air passages and vertically moves the plurality of guide pins.

3. The soldering device of claim 2, wherein, when the air passages are open, supplied air raises the plurality of guide pins to support the wire, and when the air passages are closed, the plurality of guide pins are lowered and are not in contact with the wire.

4. The soldering device of claim 2, wherein the support includes a first housing positioned on the pin adjustment block and including a plurality of first lifting holes into which a plurality of lifting pins are inserted, and
when the air passages are open, the plurality of lifting pins are raised to raise the plurality of guide pins corresponding thereto.

5. The soldering device of claim 2, wherein the support includes a second housing having a plurality of second lifting holes into which the plurality of guide pins are inserted and having an uneven part including a plurality of concave portions and protrusions and formed on an upper surface thereof, and
the plurality of guide pins overlap the uneven part.

6. The soldering device of claim 1, wherein the support selectively supports the wire by raising at least some of the plurality of guide pins using air.

7. The soldering device of claim 1, wherein the support includes a plurality of support parts spaced apart from each other in one direction and having upper surfaces on which a plurality of wires are positioned to be spaced apart from each other in the one direction.

8. A tabbing device for seating a solar cell and a wire jig on a wire on a wire transfer device and soldering the solar cell and the wire to form a solar cell module, the tabbing device comprising a soldering device including a stage on which a solar cell and a wire are seated, a body facing the stage, and a plurality of heaters positioned on a bottom surface of the body so as to face the solar cell and the wire, wherein the stage includes a support having a plurality of guide pins raised from below to support the wire toward the solar cell.
